# EUROPEAN PATENT APPLICATION

(11) **EP 4 778 696 A1**
(43) Date of publication of application: **22.07.2026**
(21) Application number: 24865166.3
(22) Date of filing: 19.08.2024
(51) Int. Cl.: B29C 45/17, B29C 33/68, B29C 45/02, B29C 45/40, H01L 21/56

(54) **RESIN ENCAPSULATION DEVICE AND RESIN ENCAPSULATION METHOD**

(30) Priority: 11.09.2023 JP 2023147103
(71) Applicant: Yamaha Robotics Co., Ltd., Musashimurayama-shi, Tokyo 208-8585 (JP)
(72) Inventor: KAWAGUCHI, Makoto, Chikuma-shi, Nagano 389-0898 (JP); NARITA, Kazuo, Chikuma-shi, Nagano 389-0898 (JP)
(74) Representative: Becker, Eberhard
(86) International application number: PCT/JP2024/029242
(87) International publication number: WO 2025/057660

(57) **Abstract**

The present invention addresses the problem of providing a resin encapsulation device and a resin encapsulation method in which a workpiece having vertical terminals mounted thereon can be reliably released at mold opening. As a means for resolving the abovementioned problem, this resin encapsulation device is equipped with a film supply mechanism (211) for supplying a film (F) to be suction-held on a mold surface (204a) of a first mold (204), and a second mold (206) has workpiece-holding parts (205) for holding workpieces (W). The first mold (204) has: insertion holes (406) through which vertical terminals (Wc) are inserted from first ends (406a), which face the workpiece-holding parts (205); and ejector pins (230) which are inserted from second ends (406b) of the insertion holes (406) and are capable of moving in mold opening/closing directions along the inside the insertion holes (406). At mold closing, the ejector pins (230) retract so that the vertical terminals (Wc) can be inserted into the insertion holes (406). At mold opening, the ejector pins (230) push the vertical terminals (Wc) to release molded articles (Wp) from the first mold (204).

## Description

### Technical Field

The present invention relates to a resin sealing apparatus and a resin sealing method.

### Related Art

As an example of a resin sealing apparatus and a resin sealing method for sealing a workpiece, which has an electronic component mounted on a substrate, using a sealing resin (hereinafter, may be simply referred to as a "resin") to process into a molded product, a resin sealing apparatus and a resin sealing method according to a transfer molding method are known.

The transfer molding method is a technique for performing resin sealing according to the following operation. A pot is provided to supply a predetermined amount of the resin to a pair of sealing regions (cavities) provided in a sealing mold including an upper mold and a lower mold. Workpieces are respectively disposed at positions corresponding to the respective sealing regions and clamped by the upper mold and the lower mold, and the resin is poured from the pot into the cavities (see Patent Document 1: Japanese Patent Application Laid-Open No. 2015-000520).

### Related Art Documents

### Patent Documents

Patent Document 1: Japanese Patent Application Laid-Open No. 2015-000520

### SUMMARY OF INVENTION

### Technical Problem

As a method for molding a workpiece with exposed vertical terminals (ports of electrical terminals erected vertically from a substrate or an electronic component) as adopted in power devices and the like, there is a method of potting a liquid resin. However, since pressurization is not performed within the mold, it is difficult to keep the molded shape of the sealing resin constant. In addition, there have been problems that voids are likely to occur and reliability of the molded product is low. In contrast, there is a method of clamping around the vertical terminals and performing resin molding with the vertical terminals exposed. However, resin burrs occur in a manner rising around the vertical terminals, and there is a problem that, with the gap narrowed between the vertical terminals and surrounding clamp members, it becomes difficult to release the molded product from the mold.

### Solution to Problem

The present invention has been made in view of the above circumstances, and an objective thereof is to provide a resin sealing apparatus and a resin sealing method capable of reliably releasing a workpiece having vertical terminals mounted thereon during mold opening.

As an embodiment, the present invention solves the above-described problem by solution means described below.

A resin sealing apparatus according to an embodiment is configured to seal a workpiece, which has a configuration in which a vertical terminal is erected, with a sealing resin using a sealing mold to process into a molded product. The sealing mold has a first mold and a second mold, one of which serves as an upper mold and the other of which serves as a lower mold. As a requirement, the resin sealing apparatus includes a film supply mechanism supplying a release film to be adsorbed to a mold surface of the first mold. The second mold has a workpiece holding part holding the workpiece. The first mold has an insertion hole through which the vertical terminal is inserted from a first end opposed to the workpiece holding part, and an ejector pin inserted from a second end of the insertion hole and movable in a mold opening-closing direction within the insertion hole. With the sealing mold closed, the ejector pin retracts in a manner allowing the vertical terminal to be inserted through the insertion hole. With the sealing mold opened, the ejector pin pushes the vertical terminal to release the molded product from the first mold.

According to the above embodiment, the workpiece having the vertical terminal mounted thereon can be reliably released during mold opening.

In addition, the first mold preferably has multiple suction holes that suck and spread the release film around the insertion hole.

In addition, with the sealing mold closed, preferably, the vertical terminal penetrates through the release film to form a film through hole while being inserted through the insertion hole, and the release film at a circumferential edge of the film through hole is pulled into a gap between the insertion hole and the vertical terminal to close the gap.

In addition, preferably, the insertion hole is formed in a sleeve member, and the sleeve member is fitted into a fitting hole provided at a predetermined position of the first mold.

In addition, preferably, in the sleeve member, the first end of the insertion hole is formed with a taper surface that gradually increases in diameter toward the workpiece holding part.

In addition, preferably, the suction holes are provided at least at two spots opposite to each other with the fitting hole provided therebetween in a plan view.

In addition, a resin sealing method according to an embodiment seals a workpiece, which has a configuration in which a vertical terminal is erected, with a sealing resin using a sealing mold to process into a molded product. The sealing mold has a first mold and a second mold, one of which serves as an upper mold and the other of which serves as a lower mold. As a requirement, the resin sealing method includes the following processes. In a film supply process, a release film supplied and adsorbed to a mold surface of the first mold. In a workpiece and sealing resin placement process, the workpiece and the sealing resin are held on the second mold. In a mold closing process, the sealing mold is closed. In a mold opening process, the sealing mold is opened. The mold closing process includes a process of inserting the vertical terminal through an insertion hole of the first mold. The mold opening process includes a process of causing an ejector pin, which is movable in a mold opening-closing direction within the insertion hole, to push the vertical terminal to release the molded product from the first mold.

In addition, preferably, the mold closing process includes a process of causing the vertical terminal to penetrate through the release film to form a film through hole while inserting the vertical terminal through the insertion hole, and pulling the release film at a circumferential edge of the film through hole into a gap between the insertion hole and the vertical terminal to close the gap.

### Effects of Invention

According to the present invention, it is possible to provide a resin sealing apparatus and a resin sealing method capable of reliably releasing a workpiece having a vertical terminal mounted thereon during mold opening.

### BRIEF DESCRIPTION OF THE DRAWINGS

[FIG. 1] FIG. 1 is a plan view showing an example of a resin sealing apparatus according to an embodiment of the present invention.
[FIG. 2] FIG. 2 is a side view showing an example of a press apparatus of the resin sealing apparatus according to the embodiment of the present invention.
[FIG. 3] FIG. 3 is a front cross-sectional view showing an example of a sealing mold of the resin sealing apparatus according to the embodiment of the present invention.
[FIG. 4] FIG. 4 is a front cross-sectional view showing an example of cavities and workpiece holding parts of the sealing mold of the resin sealing apparatus according to the embodiment of the present invention.
[FIG. 5] FIG. 5A is an enlarged view of a V part in FIG. 4. FIG. 5B is a plan view showing an example of a fitting hole, an insertion hole, and suction holes.
[FIG. 6] FIG. 6 is a view illustrating a resin sealing method according to an embodiment of the present invention.
[FIG. 7] FIG. 7 is an illustrative view following FIG. 6.
[FIG. 8] FIG. 8 is an enlarged view of an VIII part in FIG. 7.
[FIG. 9] FIG. 9 is an illustrative view following FIG. 7.
[FIG. 10] FIG. 10 is an enlarged view of a X part in FIG. 9.
[FIG. 11] FIG. 11 is an illustrative view following FIG. 9.
[FIG. 12] FIG. 12 is an enlarged view of a XII part in FIG. 11.
[FIG. 13] FIG. 13 is an illustrative view following FIG. 11.
[FIG. 14] FIG. 14A is a perspective view showing an example of a workpiece used in the resin sealing apparatus and the resin sealing method according to the embodiments of the present invention. FIG. 14B is a perspective view showing an example of a molded product formed in the resin sealing apparatus and the resin sealing method according to the embodiments of the present invention.

### DESCRIPTION OF THE EMBODIMENTS

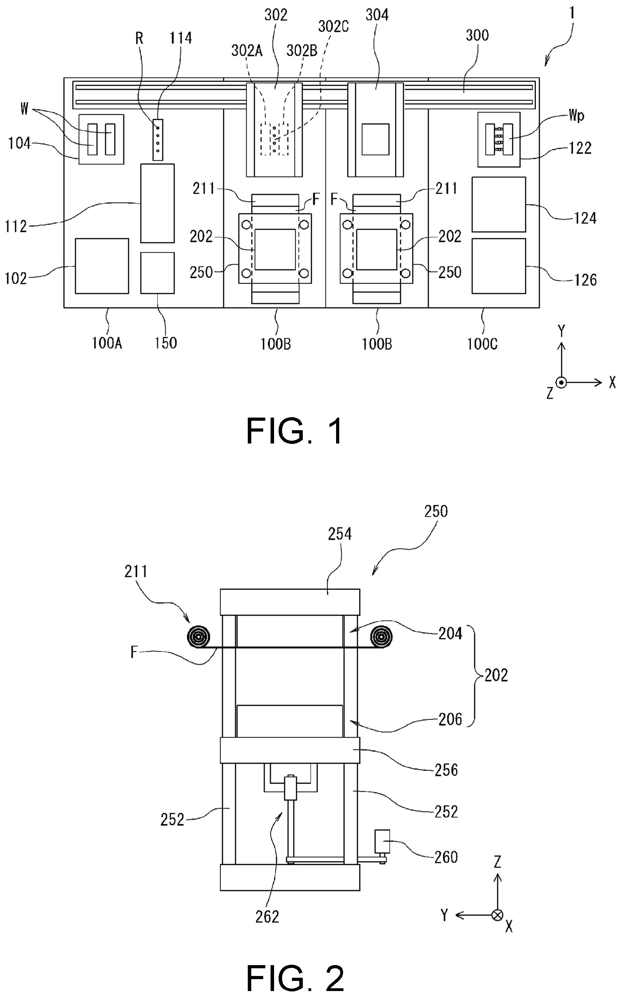

Hereinafter, embodiments of the present invention will be described in detail with reference to the drawings. FIG. 1 is a plan view (schematic view) showing an example of a resin sealing apparatus 1 according to the present embodiment. For convenience of illustration, arrows in the drawings indicate a left-right direction (X-direction), a front-rear direction (Y-direction), and an up-down direction (Z-direction) in the resin sealing apparatus 1. In addition, in all drawings for illustrating each of embodiments, members having the same functions are labeled with the same reference signs, and repeated descriptions thereof may be omitted.

The resin sealing apparatus 1 according to the present embodiment is an apparatus that performs resin sealing on a workpiece (article to be molded) W using a sealing mold 202 including a first mold (an upper mold in the present embodiment) 204 and a second mold (a lower mold in the present embodiment) 206. Hereinafter, as an example, the resin sealing apparatus 1 will be described as a resin sealing apparatus operating according to a transfer molding method, in which a workpiece W is held by a workpiece holding part 205 provided at the second mold 206, a cavity 208 (including a part of a mold surface 204a) provided at the first mold 204 in a corresponding arrangement is covered with a release film (hereinafter, may be simply referred to as a "film") F, and a clamping operation of the first mold 204 and the second mold 206 is performed to seal the workpiece W with a sealing resin R. In the present embodiment, it will be described as an example that two cavities 208 are provided at one first mold 204, and two workpieces W are disposed on one second mold 206 to collectively perform resin sealing and obtain a molded product Wp. However, the embodiment is not limited thereto, and multiple sets of the configuration described above may also be provided in parallel (not shown).

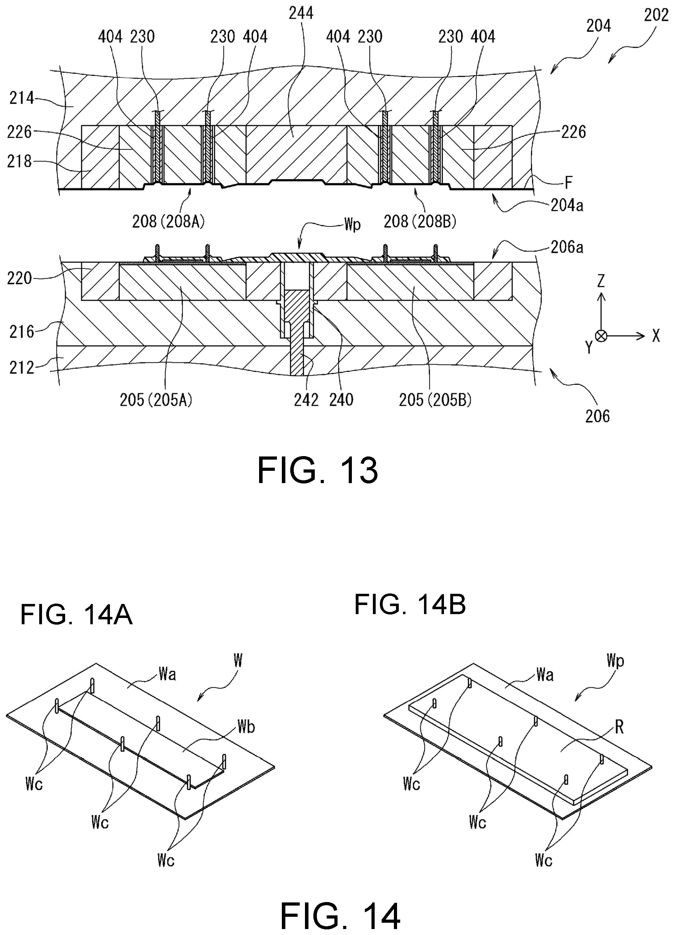

First, as shown in FIG. 14A, the workpiece W serving as a sealing target includes a configuration in which an electronic component Wb and vertical terminals Wc are provided on a substrate Wa (may also be a configuration in which the vertical terminals Wc are provided on the electronic component Wb). The number of electronic components Wb provided on one substrate Wa is set to one or more than one (e.g., in a matrix pattern), and the number of vertical terminals Wc provided at one workpiece W is set to one or more than one (six in the present embodiment).

Examples of the substrate Wa include plate-shaped members such as a resin substrate, a ceramic substrate, a metal substrate, a carrier plate, a lead frame, a wafer, etc. The shape of the substrate Wa is rectangular (strip-shaped), square, circular, etc. In addition, examples of the electronic component Wb include a semiconductor chip, a MEMS chip, a passive element, a heat dissipation plate, a conductive member, a spacer, etc. In addition, examples of the vertical terminal Wc include a pin terminal (lead pin) and the like. The shape of the vertical terminal Wc is cylindrical, prismatic, wire-shaped, etc.

Examples of a method for providing (mounting) the electronic component Wb on the substrate Wa include methods according to wire bonding mounting, flip chip mounting, etc. Alternatively, in the case of a configuration in which the substrate (a carrier plate made of glass or metal) Wa is peeled from the molded product Wp after resin sealing, there is also a method of attaching the electronic component Wb using an adhesive tape having thermal peelability or an ultraviolet curable resin that cures upon ultraviolet irradiation.

In the present embodiment, the sealing resin R is a tablet-type (e.g., cylindrical) thermosetting resin (e.g., an epoxy-based resin containing a filler, but the embodiment is not limited thereto). The sealing resin R is not limited to the above state, may have a shape other than a cylindrical shape, or may be a resin other than an epoxy-based thermosetting resin.

In addition, examples of the film F suitably include film materials excellent in heat resistance, peelability, flexibility, and stretchability, such as polytetrafluoroethylene (PTFE), polytetrafluoroethylene polymer (ETFE), PET, FEP, fluorine-impregnated glass cloth, polypropylene, polyvinylidene chloride, etc.

Next, an overview of the resin sealing apparatus 1 according to the present embodiment will be described. As shown in FIG. 1, the resin sealing apparatus 1 includes, as main configurations, a supply unit 100A that performs supply of the workpiece W and the sealing resin R, a press unit 100B that performs resin sealing on the workpiece W with the sealing resin R to process into the molded product Wp, and a storage unit 100C that performs storage of the molded product Wp. As an example, the supply unit 100A, the press unit 100B, the press unit 100B, and the storage unit 100C are sequentially disposed along the X-direction in FIG. 1. However, the embodiment is not limited to the above configuration, and the machine configuration within the unit, the number of units (particularly, the number of press units), the arrangement sequence of the units, etc. may be changed. In addition, a configuration including units other than the above may also be adopted (all not shown).

In addition, in the resin sealing apparatus 1, a control part 150 that performs operation control on each mechanism in each unit is disposed in the supply unit 100A (may also be configured to be disposed in another unit).

In addition, in the resin sealing apparatus 1, a guide rail 300 is provided in a straight line shape across the units, and a transport device (first loader) 302, which transports the workpiece W and the sealing resin R, and a transport device (second loader) 304, which transports the molded product Wp, are provided movably along the guide rail 300 between predetermined units. However, the embodiment is not limited to the above configuration, and a shared (one) transport device (loader) may also be included to transport the workpiece W, the sealing resin R, and the molded product Wp (not shown). In addition, the transport device may also be a configuration including a robot hand and the like instead of a loader.

### (Supply Unit)

Next, the supply unit 100A included in the resin sealing apparatus 1 will be described in detail.

The supply unit 100A includes a workpiece supply magazine 102 in which multiple workpieces W are stored. Herein, the workpiece supply magazine 102 is a conventional stack magazine, a conventional slit magazine, etc. The workpiece W taken out of the workpiece supply magazine 102 is placed on a workpiece table 104.

In addition, the supply unit 100A (may also be another unit) includes a resin supply part 112 that supplies the sealing resin R at a lateral position of the workpiece table 104. The resin supply part 112 is a conventional hopper, a conventional feeder, etc. Multiple (a case of four is described as an example, but the embodiment is not limited thereto; alternatively, the number may also be one) sealing resins R supplied from the resin supply part 112 are held at predetermined positions on a resin table 114.

The workpiece W placed on the workpiece table 104 and the sealing resin R held on the resin table 114 are held by the first loader 302, transported to the press unit 100B, and set at a predetermined position of the sealing mold 202. In the present embodiment, the workpiece W is placed on the workpiece holding part 205 of the second mold 206, and the sealing resin R is accommodated in a pot 240 of the second mold 206 (details of the process will be described later).

As a configuration example of the first loader 302, workpiece holding parts 302A and 302B are provided in two rows arranged along the left-right direction and are each capable of holding one workpiece W. In addition, a resin holding part 302C capable of holding multiple (a case of four is described as an example, but the embodiment is not limited thereto; alternatively, the number may also be one) sealing resins R along the front-rear direction is provided at a position between the two rows of the workpiece holding parts 302A and 302B. The workpiece holding parts 302A and 302B and the resin holding part 302C are conventional holding mechanisms (e.g., a configuration having holding claws to perform clamping, a configuration having suction holes communicating with a suction device to perform adsorption, etc.) (not shown).

As a modification example of the transport device, instead of the first loader 302 that moves in the X-direction and the Y-direction, a transport device (loader) that moves in the X-direction to perform transportation between the units and a transport device (loader) that moves in the Y-direction to perform carry-in and setting to the second mold 206 may be separately provided (not shown).

### (Press Unit)

Next, the press unit 100B included in the resin sealing apparatus 1 will be described in detail.

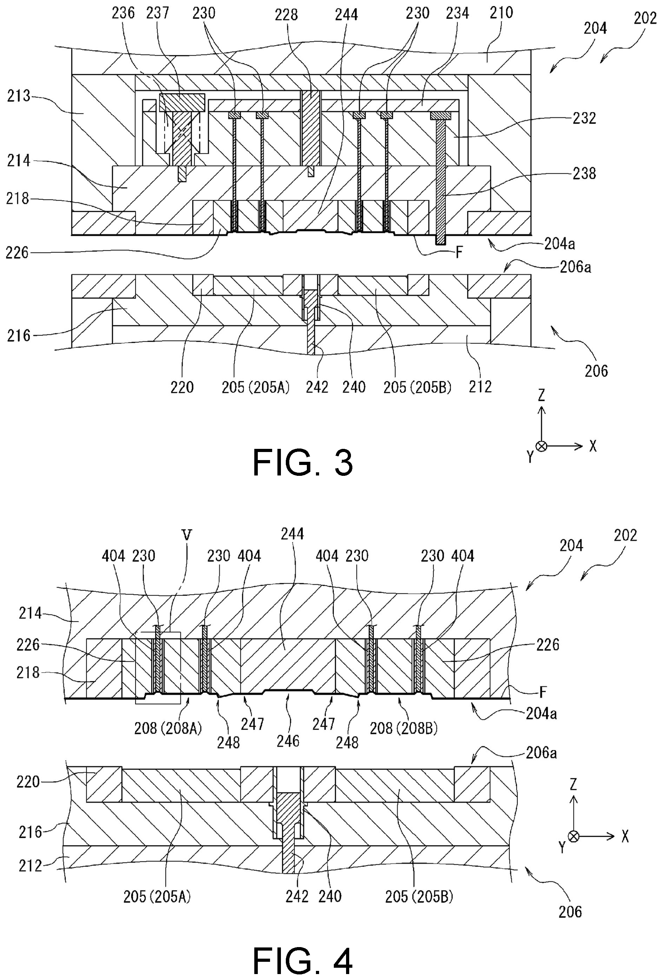

The press unit 100B includes a sealing mold 202 having a pair of molds (e.g., multiple mold blocks made of alloy tool steel, mold plates, and other members assembled together) that are opened and closed. In addition, a press apparatus 250 is included to drive the sealing mold 202 to open and close to perform resin sealing on the workpiece W. As an example, one press apparatus 250 is included herein, but multiple press apparatuses may also be included (not shown). FIG. 2 shows a side view (schematic view) of the press apparatus 250 provided in the press unit 100B, and FIG. 3 shows a front cross-sectional view (schematic view) of the sealing mold 202. In addition, FIG. 4 shows a front cross-sectional view (schematic view) of the cavity 208 and the workpiece holding part 205 of the sealing mold 202.

Herein, as shown in FIG. 2, the press apparatus 250 is configured to include a pair of platens 254 and 256, multiple tie bars 252 on which the pair of platens 254 and 256 are installed, a drive device that moves (raises and lowers) the platen 256, etc. Specifically, the drive device is configured to include a drive source (e.g., an electric motor) 260, a drive transmission mechanism (e.g., a ball screw or a toggle link mechanism) 262, etc. (however, the embodiment is not limited thereto). In the present embodiment, the platen 254 on the upper side in the vertical direction is set as a fixed platen (a platen fixed to the tie bars 252), and the platen 256 on the lower side is set as a movable platen (a platen slidably held by the tie bars 252 and raised and lowered). However, the embodiment is not limited thereto, and may also be set with the upper and lower configurations reversed, i.e., the upper side being set as a movable platen and the lower side being set as a fixed platen; alternatively, both the upper side and the lower side may be set as movable platens (none of which are shown).

On the other hand, as shown in FIG. 3, the sealing mold 202 includes a first mold 204 and a second mold 206 as a pair of molds provided between the pair of platens 254 and 256 in the press apparatus 250. In the present embodiment, on the upper side in the vertical direction is the first mold (upper mold) 204, and on the lower side is the second mold (lower mold) 206. That is, the first mold 204 is assembled to the upper platen (the fixed platen 254 in the present embodiment), and the second mold 206 is assembled to the lower platen (the movable platen 256 in the present embodiment). With the first mold 204 and the second mold 206 approaching and separating from each other, mold closing and mold opening are performed (the vertical direction (up-down direction) is the mold opening-closing direction).

In addition, in the present embodiment, as an example, a film supply mechanism 211 is provided to transport (supply) a roll-shaped film F into the sealing mold 202. In some cases, the film F may also be used in a strip shape instead of a roll shape depending on the configuration of the workpiece W.

Next, the second mold (lower mold) 206 of the sealing mold 202 will be described in detail. As shown in FIG. 3 and FIG. 4, the second mold 206 includes a mold base 212, a chase block 216, a clamp block 220, etc., and is configured by assembling these components together. As an example, the chase block 216 is fixed on the mold base 212, and the mold base 212 is fixed on the movable platen 256.

Herein, the second mold 206 is provided with multiple (a case of four is described as an example, but the embodiment is not limited thereto; alternatively, the number may also be one) cylindrical pots 240, in which the sealing resin R is accommodated, along the front-rear direction. The pot 240 is formed as a through hole continuous with the chase block 216 and the clamp block 220. In addition, within the pot 240, a plunger 242 is pushed by a conventional transfer mechanism (not shown), and the sealing resin R within the pot 240 is supplied into the cavity 208 (to be described later).

In addition, the second mold 206 is provided with a workpiece holding part 205 that holds one or multiple workpieces W in an arrangement surrounded by the clamp block 220 fixed on the chase block 216. More specifically, two workpiece holding parts 205 (first workpiece holding part 205A and second workpiece holding part 205B) are provided in an arrangement with the pot 240 disposed in the left-right direction. As an example, such a workpiece holding part 205 has suction paths (holes, grooves, etc.) communicating with a suction device (none of which are shown). Specifically, one end of the suction path communicates with a mold surface 206a of the second mold 206, and the other end is connected to the suction device provided outside the second mold 206. Accordingly, it becomes possible to drive the suction device to suck the workpiece W from the suction paths and adsorb and hold the workpiece W onto the mold surface 206a (herein, the workpiece holding part 205). Holding claws that clamp the outer circumference of the workpiece W may also be included in place of, or together with, the adsorption holding mechanism described above (not shown). The shape and the number of the workpiece holding parts 205 provided in one second mold 206 are appropriately set (one or multiple) according to the shape and the number of the workpieces W.

In addition, in the present embodiment, a second mold heating mechanism (not shown) that heats the second mold 206 to a predetermined temperature is provided. Such a second mold heating mechanism includes a heater (e.g., an electric wire heater), a temperature sensor, a power source, etc., and heating control is performed by the control part 150. As an example, the heater is built into the mold base 212 and is configured to apply heat to the entire second mold 206 and the sealing resins R within the pots 240. The second mold 206 is heated by the heater to a predetermined temperature (e.g., 100°C to 300°C).

Next, the first mold (upper mold) 204 of the sealing mold 202 will be described in detail. As shown in FIG. 3 and FIG. 4, the first mold 204 includes a mold base 210, a guide block 213, a chase block 214, a clamp block 218, etc., and is configured by combining these components together. As an example, the chase block 214 is fixed with a peripheral edge part thereof surrounded by the guide block 213, and is supported by multiple support pillars 228 erected on the mold base 210. In addition, the guide block 213 is fixed to the lower surface of the mold base 210, and the mold base 210 is fixed to the lower surface of the fixed platen 254.

Herein, in the first mold 204, a cull block 244 is provided at a position directly above the pots 240 of the second mold 206 (herein, referring to a region of a predetermined area directly above), and the cull block 244 is fixed to the chase block 214 (herein, including members fixed to the chase block 214) and has a cull 246 and (a part of) a runner 247 communicating with the cull 246 provided through the lower surface of the cull block 244. Furthermore, a cavity 208 is provided to communicate with the runner 247 and accommodate a predetermined portion of the workpiece W (a portion where the electronic component Wb and the vertical terminals Wc are provided). In addition, a boundary position (boundary region) between the runner 247 and the cavity 208 is a portion referred to as a gate 248.

The cavity 208 according to the present embodiment is provided through the lower surface of a cavity block 226 that is disposed surrounded by the clamp block 218 fixed below the chase block 214. More specifically, corresponding to the positions of the two workpiece holding parts 205 (first workpiece holding part 205A and second workpiece holding part 205B) of the second mold 206, cavities 208 (first cavity 208A and second cavity 208B) are provided on both sides in the left-right direction (or front-rear direction) with the cull block 244 interposed therebetween in a plan view. Such workpiece holding parts 205A and 205B and cavities 208A and 208B constitute one set of structural unit in which resin sealing is performed by one pot 240 and the cull 246, the runner 247, and the gate 248 corresponding thereto. In the present embodiment, multiple sets of such structural units are arranged in parallel in the front-rear direction (or left-right direction). However, the embodiment is not limited thereto, and the workpiece holding part 205 and the cavity 208 may also be provided only on one side in the left-right direction (or front-rear direction) with respect to the cull block 244 (not shown). In addition, it is also possible that only one set of the structural unit described above is provided (not shown).

Suction paths (holes, grooves, etc.) communicating with a suction device are provided in the lower surface of the clamp block 218, recess corners of the cavity 208 of the cavity block 226, etc. (not shown). Accordingly, the film F supplied from the film supply mechanism 211 can be adsorbed and held on the mold surface 204a including the recess inner surface of the cavity 208. In addition, the mold structure may perform degassing inside the cavity 208 when closing the mold to perform resin sealing.

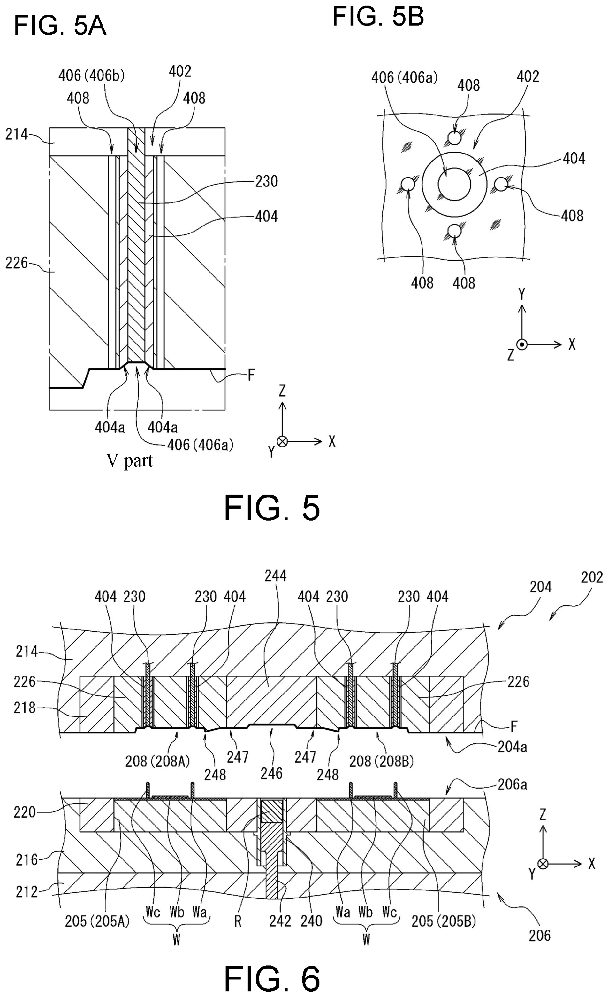

As shown in FIG. 5A, in the cavity block 226, fitting holes 402 are formed at predetermined positions. The "predetermined positions" herein refers to positions corresponding to the vertical terminals Wc of the workpiece W held on the workpiece holding part 205 of the second mold 206. A sleeve member 404 is fitted in the fitting hole 402, and an insertion hole 406 is formed in the sleeve member 404. The insertion hole 406 serves as a relief hole through which the vertical terminal Wc is inserted during mold closing (inserted from a first end 406a opposed to the workpiece holding part 205), and also serves as an insertion path for an ejector pin 230 to be described later. If the insertion hole 406 is provided directly in the cavity block 226, it is not necessarily required to use the sleeve member 404. In addition, as shown in FIG. 5B, multiple suction holes 408 are provided at predetermined intervals around the insertion hole 406 to further suck and spread the film F adsorbed and held on the mold surface 204a.

In the resin sealing apparatus 1 according to the present embodiment, when the sealing mold 202 is closed, the vertical terminal Wc penetrates through the film F spread on the mold surface 204a of the first mold 204 to form a film through hole Fa while being inserted into the insertion hole 406. At the same time, the film F at the circumferential edge of the film through hole Fa is pulled into the gap between the insertion hole 406 and the vertical terminal Wc, thus closing the gap. Accordingly, the sealing resin R can be prevented from leaking into the gap between the vertical terminal Wc and the insertion hole 406, and occurrence of resin burrs (particularly, rising of resin around the vertical terminal Wc) can be prevented on the molded product Wp.

Herein, the sleeve member 404 may be configured to be detachable from the fitting hole 402. Accordingly, the diameter, the inner surface shape, etc. of the insertion hole 406 can be changed by replacing the sleeve member 404 according to the type and the shape of the vertical terminal Wc of the workpiece W. In addition, cleanability of the first mold 204 during a miss-shot can be improved.

In the present embodiment, the sleeve member 404 is formed in a cylindrical shape, but may also be formed in a rectangular tubular shape or other tubular shapes according to the shape of the fitting hole 402. In the sleeve member 404, the first end 406a of the insertion hole 406 is formed with a taper surface 404a that gradually increases in diameter toward the workpiece holding part 205. Accordingly, tip misalignment of a vertical terminal Wc of a workpiece W that has low accuracy in mounting position or has low verticality can be corrected during mold closing, and accurately guided from the first end 406a into the insertion hole 406. The sleeve member 404 is formed of the same material (e.g., alloy tool steel) as the sealing mold 202 herein, but may also be formed of other materials (e.g., resin material).

In addition, the suction holes 408 are provided at least at two spots (at four spots arranged at an angle of 90 degrees in the present embodiment) opposite to each other with the fitting hole 402 provided therebetween in a plan view. Accordingly, since the film F at the circumferential edge of the insertion hole 406 can be spread, the film through hole Fa can be formed easily during mold closing. In other words, the film F can be prevented from remaining unpenetrated (the film through hole Fa not formed) and from following the vertical terminal Wc and being excessively pulled into the gap between the vertical terminal Wc and the insertion hole 406. In addition, during molding, the sealing resin R can be prevented from entering the gap between the film through hole Fa and the mold surface 204a via the film through hole Fa, and the film F and the molded product Wp can be reliably released from the mold during mold opening after molding.

Herein, as a configuration characteristic of the present embodiment, the first mold 204 is provided with an ejector mechanism that releases the molded product Wp from the first mold 204 upon mold opening. The ejector mechanism includes ejector pins 230, an ejector pin plate 232, a retainer plate 234, a spring 236, a shoulder bolt 237, and a return pin 238. As an example, one end side (upper side) of the ejector pin 230 serves as a base end of a diameter-enlarged part and is clamped between the ejector pin plate 232 and the retainer plate 234, and the other end side (lower side) is inserted through the insertion hole 406 movably in the mold opening-closing direction (inserted into the insertion hole 406 from a second end 406b). In addition, a counterbore is formed on the ejector pin plate 232, and a male threaded part of the shoulder bolt 237 is screwed and fixed to the chase block 214. The spring 236 is inserted around the shoulder bolt 237, and since the spring 236 is elastically biased between a diameter-enlarged part of the head of the shoulder bolt 237 and the counterbore, the ejector pin plate 232 is constantly biased in the mold closing direction (downward direction) and abuts against the chase block 214. The shoulder bolt 237 may be substituted with a collar, a washer, and a bolt. One end side (upper side) of the return pin 238 serves as a base end of a diameter-enlarged part and is fixed to the ejector pin plate 232, and the tip (lower side) is inserted through the chase block 214 and protrudes from the mold surface 204a.

According to the ejector mechanism described above, during mold closing, since the return pin 238 protrudes from the mold surface 204a of the first mold 204, the return pin 238 abuts against the mold surface 206a of the second mold 206, and the ejector pin plate 232 is pushed up by the protrusion amount. Accordingly, the vertical terminal Wc of the workpiece W held on the workpiece holding part 205 of the second mold 206 can be configured in a state capable of being inserted through the insertion hole 406 (first end 406a). On the other hand, during mold opening, with the biasing of the spring 236, the ejector pins 230 move in the mold closing direction (toward the first end 406a of the insertion hole 406) together with the ejector pin plate 232 and the retainer plate 234. Accordingly, the vertical terminal Wc of the resin-sealed molded product Wp can be pushed to reliably release the molded product Wp from the first mold 204. However, in a configuration in which the return pin 238 protrudes during mold opening, a problem arises in that the film F is stretched by the protrusion amount. To avoid this, as a modification example, the lower end of the return pin 238 may be configured to be flush with the mold surface 204a of the first mold 204, and a push-up pin (not shown) (pushed toward the first mold 204 side during mold closing by a movable mechanism (not shown)) provided at the second mold 206 pushes up the return pin 238, so that the ejector pins 230 move in the mold opening direction (toward the second end 406b of the insertion hole 406) together with the ejector pin plate 232 and the retainer plate 234.

In addition, in the present embodiment, a first mold heating mechanism (not shown) that heats the first mold 204 to a predetermined temperature is provided. Such a first mold heating mechanism includes a heater (e.g., an electric wire heater), a temperature sensor, a power source, etc., and heating control is performed by the control part 150. As an example, the heater is built into the mold base 210 and is configured to apply heat to the entire first mold 204, the molten sealing resin R filled in the cavity 208, and the resin flow paths 246, 247, and 248. With such a heater, the first mold 204 is heated to a predetermined temperature (e.g., 100°C to 300°C).

### (Storage Unit)

Next, the storage unit 100C included in the resin sealing apparatus 1 will be described in detail.

The molded product Wp (in a state including unwanted resin portions) molded in the press unit 100B is held by the second loader 304, carried out of the sealing mold 202, and transported to the storage unit 100C. A holding mechanism for the molded product Wp in the second loader 304 is a conventional holding mechanism (e.g., a configuration that clamps with holding claws, a configuration that adsorbs with suction holes communicating with a suction device, etc.) (not shown).

As a modification example of the transport device described above, a transport device (loader) that moves in the X-direction to perform transportation between the units and a transport device (loader) that moves in the Y-direction to perform carry-out from the sealing mold 202 may be separately provided (not shown), in place of the second loader 304 that moves in the X-direction and the Y-direction.

The storage unit 100C includes a molded product table 122 on which the molded product Wp transported by the second loader 304 is placed, and a degate mechanism 124 that removes the unwanted resin portions from the molded product Wp placed on the molded product table 122. The molded product Wp with the unwanted resin portions removed is stored in a storage magazine 126 in which multiple molded products Wp are stored. Herein, a conventional stack magazine, a conventional slit magazine, etc. is used as the storage magazine 126.

### (Resin Sealing Operation)

Next, processes of the resin sealing method according to the present embodiment performed using the above resin sealing apparatus 1 will be described. Herein, it is described as an example that two sets of cavities 208 are provided in one first mold (upper mold) 204, and two workpieces W are arranged in parallel on one second mold (lower mold) 206 to collectively perform resin sealing to obtain a molded product Wp. However, the embodiment is not limited thereto, and it is also possible to dispose one workpiece W, or arrange multiple workpieces W in parallel in a matrix in the front-rear and left-right directions, to perform resin sealing. FIG. 6 to FIG. 13 are diagrams illustrating respective processes, and are front cross-sectional views taken in the same direction as FIG. 3.

First, a first preparation process is performed. The first preparation process includes the following processes. A heating process (first mold heating process) is performed to adjust and heat the first mold 204 to a predetermined temperature (e.g., 100°C to 300°C) by the first mold heating mechanism. In addition, a heating process (second mold heating process) is performed to adjust and heat the second mold 206 to a predetermined temperature (e.g., 100°C to 300°C) by the second mold heating mechanism. In addition, a film supply process is performed to operate the film supply mechanism 211 to supply a new film F, and adsorb the film F to cover a predetermined region of the mold surface 204a including the inner surfaces of the cavities 208 of the first mold 204. The film supply process includes a process of sucking and spreading the film F from the suction holes 408 provided between the inner circumferential surface of the fitting hole 402 and the outer circumferential surface of the sleeve member 404.

A second preparation process is performed before or after, or in parallel with, the first preparation process. The second preparation process includes the following processes. A process is performed to carry the workpieces W out one by one from the workpiece supply magazine 102 by a conventional pusher (not shown), and place the workpieces W on the upper surface of the workpiece table 104 (a conventional pickup mechanism or the like may also be used in combination). In addition, a process is performed to carry the cylindrical tablet-shaped sealing resins R out one by one from the resin supply part 112 by a conventional feeder, a conventional elevator, etc. (not shown), and hold multiple (e.g., four) sealing resins R at predetermined positions on the resin table 114.

After the second preparation process, a workpiece and sealing resin pickup process is performed to hold the workpiece W and the sealing resin R by the first loader 302. Specifically, the first loader 302 is moved to directly above the workpiece table 104. Next, the workpiece table 104 is raised (or the first loader 302 is lowered), and the workpieces W are held by the workpiece holding parts 302A and 302B (in the present embodiment, the workpiece holding parts 302A and 302B each hold one workpiece W). Next, the first loader 302 is moved to directly above the resin table 114. Next, the resin table 114 is raised (or the first loader 302 is lowered), and the sealing resins R are held by the resin holding part 302C (in the present embodiment, the resin holding part 302C holds four sealing resins R).

After the workpiece and sealing resin pickup process, a workpiece and sealing resin placement process is performed to transport the workpieces W and the sealing resins R into the sealing mold 202, and hold the workpieces W and the sealing resins R at predetermined positions of the second mold 206. Specifically, the first loader 302 holding multiple (two in the present embodiment) workpieces W and multiple (four in the present embodiment) sealing resins R is moved into the sealing mold 202. Next, the workpieces W are respectively held (placed) on the workpiece holding parts 205 (workpiece holding parts 205A and 205B in the present embodiment) of the second mold 206, and the sealing resins R are respectively held (accommodated) in the multiple (four in the present embodiment) pots 240 of the second mold 206 (see FIG. 6). During transportation, a process (preheating process) may be performed to preheat the workpieces W and the sealing resins R by a heater (not shown) provided in the first loader 302.

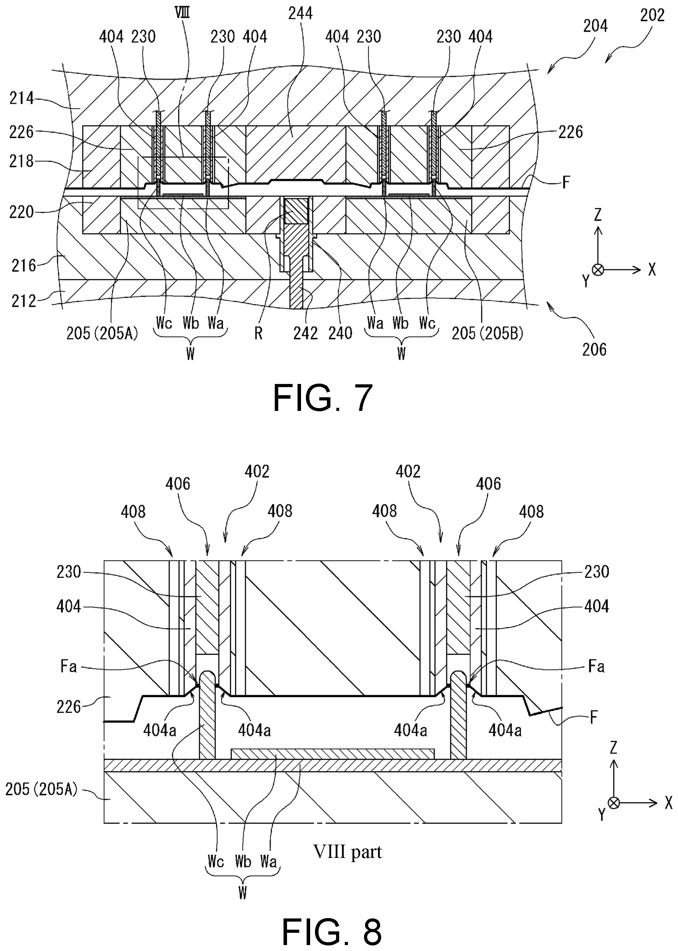

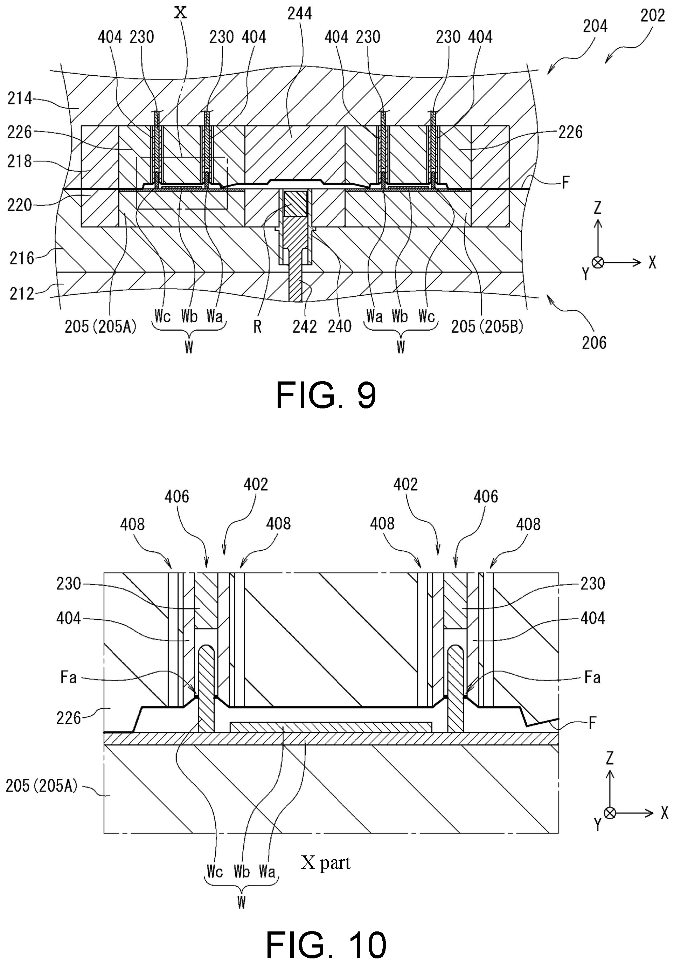

After the workpiece and sealing resin placement process, a mold closing process is performed to close the sealing mold 202. Specifically, the drive source 260 and the drive transmission mechanism 262 are driven to move the movable platen 256 upward, and move the second mold 206 toward the first mold 204 (i.e., upward). Herein, the return pin 238 of the first mold 204 abuts against the mold surface 206a of the second mold 206 and is pushed up (alternatively, in the case where the second mold 206 has a push-up pin (modification example above), the push-up pin of the second mold 206 pushes up the return pin 238 of the first mold 204), and thus the ejector pins 230, together with the ejector pin plate 232 and the retainer plate 234, move in the mold opening direction (toward the second end 406b of the insertion hole 406). In parallel, the vertical terminals Wc of the workpieces W held on the workpiece holding parts 205 of the second mold 206 penetrate through the film F to form film through holes Fa, and the vertical terminals Wc are inserted through the insertion holes 406 (first ends 406a) of the first mold 204 (see FIG. 7 and FIG. 8). The movement of the second mold 206 goes on until the cavity block 226 of the first mold 204 abuts against the workpiece W (substrate Wa) and the workpiece W is in a clamped state (see FIG. 9 and FIG. 10). Herein, the film F at the circumferential edge of the film through holes Fa of the second mold 206 is pulled into the gap between the insertion hole 406 and the vertical terminal Wc, and the gap is in a closed state.

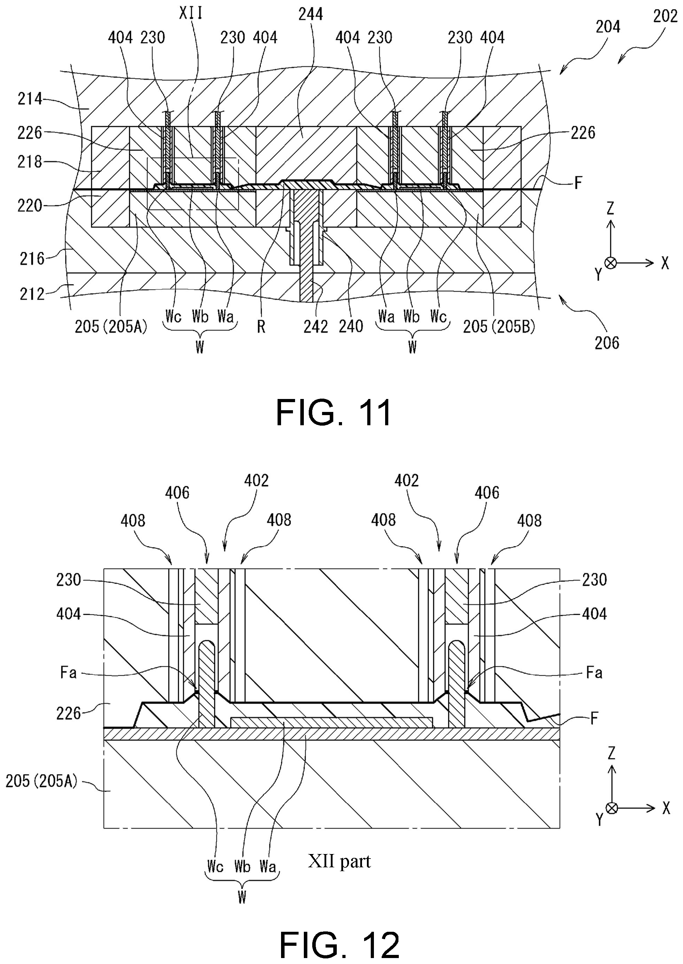

After the mold closing process, a resin sealing process is performed to seal the workpieces W with the sealing resins R to process into a molded product Wp. Specifically, the transfer drive mechanism is operated to push the plunger 242 toward the first mold 204, press the molten sealing resins R against the cull 246 of the first mold 204, and pressure-feed the sealing resins R into the cavities 208 through the runner 247 and the like communicating with the cull 246 (see FIG. 11 and FIG. 12). Accordingly, the sealing resins R are thermally cured and the resin sealing (transfer molding) is completed.

After the resin sealing process, a mold opening process is performed to open the sealing mold 202 (including separation from the used film F). Specifically, the drive source 260 and the drive transmission mechanism 262 are driven to move the movable platen 256 downward, and separate the second mold 206 from the first mold 204. During separation, the return pin 238, which has been embedded up to the mold surface 204a, protrudes due to the biasing force of the spring 236, and thus the ejector pins 230 can push out the vertical terminals Wc to reliably release the mold (see FIG. 13). Alternatively, in the case where the second mold 206 has a push-up pin (modification example above), during separation, upon release of the push-up on the return pin 238 of the first mold 204 by the push-up pin of the second mold 206, the ejector pins 230 move in the mold closing direction (toward the first end 406a of the insertion hole 406) together with the ejector pin plate 232 and the retainer plate 234 due to the biasing force of the spring 236 in the mold closing direction, and push the vertical terminals Wc of the resin-sealed molded product Wp, to release the molded product Wp from the first mold 204. The reason for providing the push-up pin is that the mold release timing can be set separately from the mold opening.

After the mold opening process, a molded product carry-out process is performed to carry, by the second loader 304, the molded product Wp (in the present embodiment, including unwanted resin portions such as a cull part, a runner part, a gate part, etc., with two workpieces W connected via such portions) out of the sealing mold 202 and carry to the molded product table 122. In addition, after, or in parallel therewith, the molded product carry-out process, a film supply process is performed to operate the film supply mechanism 211 to send out the used film F from inside the sealing mold 202, and send in and set a new film F into the sealing mold 202.

After the molded product carry-out process, a degate process is performed to remove the unwanted resin portions such as the cull part, the runner part, the gate part, etc. from the molded product Wp in the degate mechanism 124. Next, a process is performed to carry the molded products Wp (with the unwanted resin portions removed) one by one into the storage magazine 126 by a conventional pusher or the like (not shown). Before such processes, a process may be performed to post-cure the molded product Wp.

The above are the main processes of the resin sealing method performed using the resin sealing apparatus 1. However, the above process sequence is an example, and the sequence may be changed or the processes may be performed in parallel as long as no problem arises.

As described above, according to the present invention, it is possible to provide a resin sealing apparatus and a resin sealing method capable of reliably releasing a workpiece on which vertical terminals are mounted during mold opening.

The present invention is not limited to the above embodiments, and various modifications are possible within ranges without departing from the present invention. In the above embodiment, the film through hole Fa is formed in the film F by the vertical terminal Wc of the workpiece W during mold closing in the resin sealing process, but a film with a film through hole Fa formed in advance may also be used (a mechanism for forming the film through hole Fa may be disposed). In addition, after the film F is adsorbed to the first mold 204 and before the film through hole Fa is formed in the film F by the vertical terminal Wc, the film through hole Fa may be formed in the film F using a dedicated hole-punching jig (not shown). Accordingly, particularly in the case where the tip shape of the vertical terminal Wc is not a tapered shape (e.g., a conical shape, a bullet shape, etc.), the film F can be prevented from remaining unpenetrated (the film through hole Fa not formed), and from following the vertical terminal Wc and being excessively pulled into the gap between the vertical terminal Wc and the insertion hole 406.

In addition, in the above embodiments, the resin sealing apparatus and the resin sealing method according to the transfer molding method have been described as an example, but the embodiments are also applicable to a resin sealing apparatus and a resin sealing method according to a compression molding method.

## Claims

1. A resin sealing apparatus configured to seal a workpiece, which has a configuration in which a vertical terminal is erected, with a sealing resin using a sealing mold to process into a molded product, the sealing mold having a first mold and a second mold, one of which serves as an upper mold and the other of which serves as a lower mold, the resin sealing apparatus comprising:
a film supply mechanism supplying a release film to be adsorbed to a mold surface of the first mold, wherein
the second mold has a workpiece holding part holding the workpiece,
the first mold has:
an insertion hole through which the vertical terminal is inserted from a first end opposed to the workpiece holding part; and
an ejector pin inserted from a second end of the insertion hole and movable in a mold opening-closing direction within the insertion hole,
with the sealing mold closed, the ejector pin retracts in a manner allowing the vertical terminal to be inserted through the insertion hole, and
with the sealing mold opened, the ejector pin pushes the vertical terminal to release the molded product from the first mold.

2. The resin sealing apparatus according to claim 1, wherein
the first mold has a plurality of suction holes that suck and spread the release film around the insertion hole.

3. The resin sealing apparatus according to claim 2, wherein
with the sealing mold closed, the vertical terminal penetrates through the release film to form a film through hole while being inserted through the insertion hole, and the release film at a circumferential edge of the film through hole is pulled into a gap between the insertion hole and the vertical terminal to close the gap.

4. The resin sealing apparatus according to claim 3, wherein
the insertion hole is formed in a sleeve member, and
the sleeve member is fitted into a fitting hole provided at a predetermined position of the first mold.

5. The resin sealing apparatus according to claim 4, wherein
in the sleeve member, the first end of the insertion hole is formed with a taper surface that gradually increases in diameter toward the workpiece holding part.

6. The resin sealing apparatus according to claim 5, wherein
the suction holes are provided at least at two spots opposite to each other with the fitting hole provided therebetween in a plan view.

7. A resin sealing method that seals a workpiece, which has a configuration in which a vertical terminal is erected, with a sealing resin using a sealing mold to process into a molded product, the sealing mold having a first mold and a second mold, one of which serves as an upper mold and the other of which serves as a lower mold, the resin sealing method comprising:
a film supply process of supplying and adsorbing a release film to a mold surface of the first mold;
a workpiece and sealing resin placement process of holding the workpiece and the sealing resin on the second mold;
a mold closing process of closing the sealing mold; and
a mold opening process of opening the sealing mold, wherein
the mold closing process comprises a process of inserting the vertical terminal through an insertion hole of the first mold, and
the mold opening process comprises a process of causing an ejector pin, which is movable in a mold opening-closing direction within the insertion hole, to push the vertical terminal to release the molded product from the first mold.

8. The resin sealing method according to claim 7, wherein
the mold closing process comprises a process of causing the vertical terminal to penetrate through the release film to form a film through hole while inserting the vertical terminal through the insertion hole, and pulling the release film at a circumferential edge of the film through hole into a gap between the insertion hole and the vertical terminal to close the gap.
